# EUROPÄISCHE PATENTSCHRIFT

(11) **EP 1 961 018 B1**
(45) Veröffentlichungstag und Bekanntmachung des Hinweises auf die Patenterteilung: **09.09.2009**
(21) Anmeldenummer: 06829443.8
(22) Anmeldetag: 08.12.2006
(51) Int. Cl.: H01C 3/02, G01R 19/00

(54) **NIEDEROHMIGER KOAXIALWIDERSTAND ZUR STROMMESSUNG**
LOW-RESISTANCE COAXIAL RESISTOR FOR CURRENT MEASUREMENT
RÉSISTANCE COAXIALE DE FAIBLE VALEUR OHMIQUE POUR LA MESURE DU COURANT

(30) Priorität: 13.12.2005 DE 102005059561
(43) Veröffentlichungstag der Anmeldung: 27.08.2008
(73) Patentinhaber: Isabellenhütte Heusler GmbH & Co.KG, 35683 Dillenburg (DE)
(72) Erfinder: HETZLER, Ullrich, 35688 Dillenburg/Oberscheld (DE)
(74) Vertreter: Beier, Ralph
(86) Internationale Anmeldenummer: PCT/EP2006/011847
(87) Internationale Veröffentlichungsnummer: WO 2007/068409

(56) Entgegenhaltungen:
- DE-A1- 10 258 115
- DE-U1- 8 510 187
- US-A- 5 596 309

## Beschreibung

Die Erfindung betrifft einen Koaxialwiderstand zur Strommessung und dessen Verwendung.

Zur Strommessung im Hochstrombereich ab einigen 100 A bis zu 10 kA und darüber werden fast ausschließlich magnetische Kompensationswandler eingesetzt, die das durch den zu messenden Strom erzeugte Magnetfeld als Messgröße nutzen. Die Nachteile derartiger Kompensationswandler sind großes Bauvolumen, hoher Offset, limitierte Linearität und ein hoher Elektronik-Aufwand für die Messwertabbildung auf der Sekundärseite. Darüber hinaus sind derartige magnetische Kompensationswandler vergleichsweise teuer. Vorteilhaft an dem Einsatz magnetischer Kompensationswandler zur Strommessung ist dagegen die durch das Messverfahren automatisch gegebene galvanische Trennung des Messteils vom Hauptstromkreis.

Zur Messung kleinerer Ströme bis 1000 A werden deshalb sogenannte Shunts eingesetzt, die beispielsweise aus EP 0 605 800 B1 bekannt sind. Dabei handelt es sich um niederohmige Messwiderstände, durch die der zu messende Strom fließt, so dass durch eine Messung des Spannungsabfalls über dem Shunt der elektrische Strom entsprechend dem ohmschen Gesetz berechnet werden kann.

Bei sehr hohen Strömen im kA-Bereich führen derartige Shunts jedoch zu verschiedenen Problemen. Zum einen verursachen die hohen Ströme entsprechend starke Magnetfelder, was zu entsprechend hohen Induktionsspannungen führt. Zum anderen macht sich bei höheren Frequenzen des zu messenden Stroms bei großen Strömen der Skin-Effekt bemerkbar, was zu einem starken Anstieg des effektiven Widerstandswerts führt und die Strommessung beeinträchtigt.

Diese Probleme werden durch sogenannte Koaxialwiderstände gelöst, die im Wesentlichen aus einem innen liegenden Manganin^{®}-Stab oder -Rohr als Stromzuleitung und einem damit in Reihe geschalteten, außen liegenden Kupfer-Rohr als Stromrückleitung bestehen. Die innen liegende Stromhinleitung und die außen liegende Stromrückleitung sind hierbei koaxial zueinander angeordnet und führen den zu messenden Strom in entgegen gesetzten Richtungen, so dass sich die von der Stromhin- und der Stromrückleitung erzeugten Magnetfelder weitgehend aufheben. Der Spannungsabgriff an dem Manganin^{®}-Stab oder -Rohr erfolgt hierbei innen an der Verbindung zwischen dem Manganin^{®}-Stab oder -Rohr und dem Kupfer-Rohr. Ein ähnlicher Koaxialwiderstand ist beispielsweise aus US 5 596 309 bekannt.

Nachteilig an diesem bekannten Koaxialwiderstand ist zunächst die relativ große Verlustleistung, die quadratisch mit dem zu messenden Strom ansteigt und ab einem bestimmten Stromgrenzwert zu einer unzulässigen Überhitzung des Manganins^{®} führt, was den Strommessbereich nach oben begrenzt.

Ein weiterer Nachteil des vorstehend beschriebenen bekannten Koaxialwiderstands ist der schwierige Spannungsabgriff an dem innen liegenden Manganin^{®}-Stab oder -Rohr, wodurch die Messgenauigkeit beeinträchtigt wird, da in der durch die Spannungsabgriffe gebildeten Leiterschleife Störspannungen induziert werden können.

Zum Stand der Technik ist ferner hinzuweisen auf DE 102 58 115 A1 und DE 85 10 187 U1. In diesen Druckschriften werden Messwiderstände in koaxialer Anordnung gezeigt, bei denen das Widerstandselement Teil des inneren Stromleiters ist.

Der Erfindung liegt deshalb die Aufgabe zugrunde, einen verbesserten Koaxialwiderstand zu schaffen, der eine Messung möglichst großer elektrischer Ströme mit einer möglichst hohen Messgenauigkeit ermöglicht.

Diese Aufgabe wird durch einen erfindungsgemäßen Koaxialwiderstand gemäß Anspruch 1 gelöst.

Die Erfindung umfasst die allgemeine technische Lehre, das niederohmige Widerstandselement in dem Koaxialwiderstand nicht - wie bei dem eingangs beschriebenen bekannten Koaxialwiderstand - innen anzuordnen, sondern außen. Die außen liegende Anordnung des niederohmigen Widerstandselements ermöglicht vorteilhaft einen Spannungsabgriff mit geringerer Störempfindlichkeit.

Vorzugsweise erstreckt sich das niederohmige Widerstandselement hierbei nicht - wie bei dem eingangs beschriebenen bekannten Koaxialwiderstand - über dessen gesamte Länge, sondern in axialer Richtung nur über einen kleinen Teil der Länge des Koaxialwiderstands. Dies führt im Vergleich zu dem eingangs beschriebenen bekannten Koaxialwiderstand zu einem kleineren Widerstandswert des niederohmigen Widerstandselements, wodurch bei der Strommessung die Verlustleistung herabgesetzt wird, so dass der Strommessbereich nach oben bis in den kA-Bereich erweitert werden kann.

In einem bevorzugten Ausführungsbeispiel der Erfindung weist der Koaxialwiderstand einen innen liegenden Stromleiter in Form eines Stabs oder eines Rohrs und einen außen liegenden Stromleiter in Form von mehreren Ringen auf, die den Stab bzw. das Rohr des innen liegenden Stromleiters umgeben. Das niederohmige Widerstandselement besteht hierbei ebenfalls aus einem Ring, der den Stab bzw. das Rohr des innen liegenden Stromleiters umgibt und in axialer Richtung zwischen den Ringen des innen liegenden Stromleiters angeordnet ist. Die großen Querschnitte der vorzugsweise aus Kupfer bestehenden Stromleiter und des vorzugsweise aus Manganin^{®} bestehenden Widerstandselements führen in Verbindung mit der hohen elektrischen und thermischen Leitfähigkeit von Kupfer zu einer großen Wärmekapazität, einem sehr niedrigen Wärmewiderstand von weniger als 0,1 K/W sowie einem nur geringfügig erhöhten Gesamtwiderstand des Koaxialwiderstands, wodurch eine sehr hohe Puls- und Dauerbelastbarkeit des erfindungsgemäßen Koaxialwiderstands ermöglicht wird.

Vorzugsweise weist das niederohmige Widerstandselement hierbei einen kleineren stromführenden Querschnitt auf als der innen liegende Stromleiter, was sich beispielsweise in einer außen liegenden Stufe am Übergang von dem außen liegenden Stromleiter zu dem niederohmigen Widerstandselement äußert. Eine solche Stufe zwischen dem außen liegenden Stromleiter und dem niederohmigen Messwiderstand führt vorteilhaft zur Erzeugung eines sogenannten Stromschattens.

Weiterhin weist der erfindungsgemäße Koaxialwiderstand vorzugsweise zwei Spannungsabgriffe zur Messung der über dem niederohmigen Widerstandselement abfallenden elektrischen Spannung auf, wobei die Spannungsabgriffe ebenfalls außen angeordnet sind. Durch diesen Spannungsabgriff an der Außenseite des Koaxialwiderstands bilden die Spannungsabgriffe eine wesentlich kleinere Leiterschleife als bei dem eingangs beschriebenen bekannten Koaxialwiderstand, wodurch die Störempfindlichkeit stark herabgesetzt wird.

Die Spannungsabgriffe können hierbei angeschweißt, angelötet oder angeklebt werden, jedoch ist die Erfindung hinsichtlich der Befestigung der Spannungsabgriffe an dem Koaxialwiderstand nicht auf diese Befestigungsarten beschränkt, sondern grundsätzlich auch mit anderen Befestigungsarten realisierbar.

In einem bevorzugten Ausführungsbeispiel der Erfindung ist an dem Koaxialwiderstand außen eine Leiterplatte fest angebracht, die mit den beiden Spannungsabgriffen verbunden ist, wobei die Leiterplatte beispielsweise aufgelötet oder mit einem elektrisch leitfähigen Kleber an der Außenseite des Koaxialwiderstands befestigt sein kann.

In einer Variante der Erfindung weist die Leiterplatte einen Anschluss für ein Koaxialkabel auf, z.B. in Form eines BNC-Steckers oder einer BNC-Buchse (BNC : Bayonet Navy Connectory). Auf diese Weise kann der Koaxialwiderstand über ein Koaxialkabel mit einem Spannungsmessgerät verbunden werden, das den Spannungsabfall über dem niederohmigen Widerstandselement misst, woraus dann der elektrische Strom berechnet werden kann.

In einer anderen Variante der Erfindung trägt die Leiterplatte dagegen ein IC zur Spannungsmessung, das mit den beiden Spannungsabgriffen verbunden ist und die über dem niederohmigen Widerstand abfallende Spannung misst. Die Spannungsmessung erfolgt hierbei also direkt auf der Leiterplatte durch das IC, wobei der Messwert über eine Schnittstelle auf der Leiterplatte zu einer Auswertungseinheit übertragen werden kann.

Die zur Übertragung des Messwerts dienende Schnittstelle ist vorzugsweise potenzialfrei und trennt den Koaxialwiderstand galvanisch von der externen Auswertungseinheit. Beispielsweise kann hierzu eine Infrarot-Schnittstelle eingesetzt werden.

Vorzugsweise ist die Leiterplatte hierbei in einer Montagemulde an der Außenseite des Koaxialwiderstands versenkt angeordnet, wobei die Leiterplatte in der Montagemulde mit einer Vergussmasse vergossen sein kann, um die Leiterplatte mit dem IC gegen Umwelteinflüsse zu schützen.

Weiterhin ist es vorteilhaft, wenn das niederohmige Widerstandselement an der Außenseite eine elektrische Isolierung trägt, die beispielsweise durch einen Schutzlack gebildet werden kann.

Ferner ist zu erwähnen, dass der innen liegende Stromleiter bei dem erfindungsgemäßen Koaxialwiderstand vorzugsweise eine Stromzuleitung ist, während der außen liegende Stromleiter vorzugsweise eine Stromrückleitung ist. Es ist jedoch alternativ auch möglich, dass der außen liegende Stromleiter mit dem daran angeordneten niederohmigen Widerstandselement eine Stromzuleitung ist, wohingegen der innen liegende Stromleiter eine Stromrückleitung ist.

Vorzugsweise besteht das niederohmige Widerstandselement bei dem erfindungsgemäßen Koaxialwiderstand aus einer Kupfer-Mangan-Nickel-Legierung, wie beispielsweise Manganin^{®}. Eine derartige Zusammensetzung des niederohmigen Widerstandselements ist wegen der hohen Temperaturkonstanz von Manganin^{®} und der Unempfindlichkeit gegenüber Umgebungseinflüssen vorteilhaft.

Die Stromleiter bestehen dagegen vorzugsweise aus Kupfer oder einer Kupfer-Legierung, wodurch ein extrem niedriger ohmscher Widerstand der Stromleiter erreicht wird, der sogar im µOhm-Bereich liegen kann. Vorzugsweise ist der Widerstand der Stromleiter hierbei wesentlich kleiner als der Widerstand des niederohmigen Widerstandselements.

Ferner umfasst die Erfindung nicht nur den vorstehend beschriebenen erfindungsgemäßen Koaxialwiderstand, sondern auch die neuartige Verwendung des erfindungsgemäßen Koaxialwiderstands zur Strommessung gemäß Anspruch 21, insbesondere im kA-Bereich.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine seitliche Querschnittsansicht eines erfindungsgemäßen Koaxialwiderstands,
- Figur 1B: eine Aufsicht auf den Koaxialwiderstand gemäß Figur 1A,
- Figur 2A: eine seitliche Querschnittsansicht eines alternativen Ausführungsbeispiels eines erfindungsgemäßen Koaxialwiderstands,
- Figur 2B: eine Detailansicht des Ausschnitts "X" aus Figur 2A,
- Figur 3A: eine Seitenansicht eines alternativen Ausführungsbeispiels eines erfindungsgemäßen Koaxialwiderstands,
- Figur 3B: eine Aufsicht auf den Koaxialwiderstand gemäß Figur 3A sowie
- Figur 4: ein alternatives Ausführungsbeispiel zu dem Koaxialwiderstand gemäß Figur 1A.

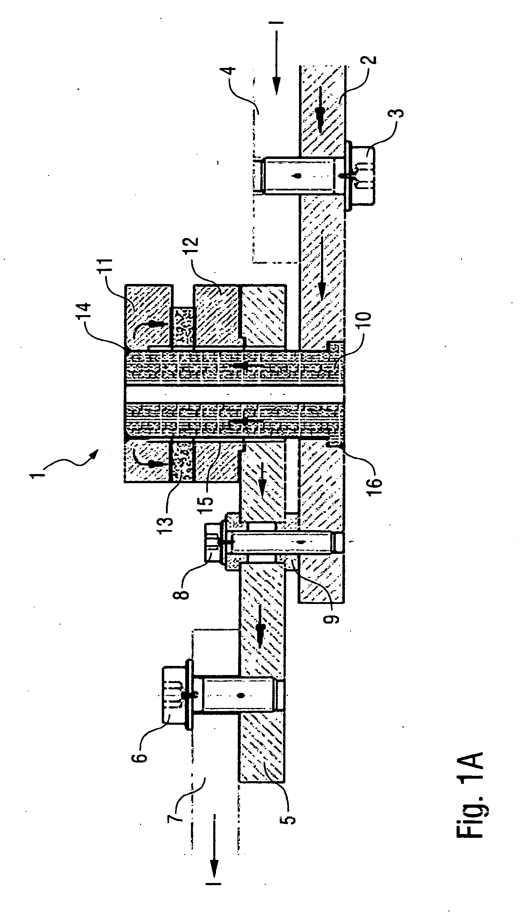

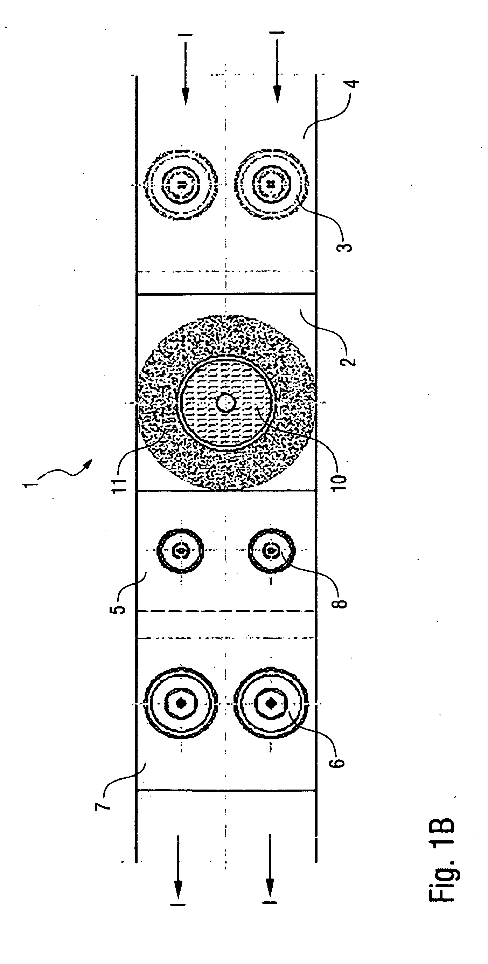

Die Figuren 1A und 1B zeigen ein bevorzugtes Ausführungsbeispiel eines erfindungsgemäßen Koaxialwiderstands 1, der zur Strommessung im kA-Bereich eingesetzt werden kann, wobei der Spannungsabfall über dem Koaxialwiderstand 1 gemessen wird, woraus dann entsprechend dem ohmschen Gesetz der elektrische Strom berechnet werden kann, der durch den Koaxialwiderstand 1 fließt.

Die Zuführung des zu messenden elektrischen Stroms erfolgt hierbei über ein plattenförmiges Anschlusselement 2, das mittels einer Schraube 3 mit einer externen Stromschiene 4 verschraubt ist.

Die Ableitung des elektrischen Stroms von dem Koaxialwiderstand 1 erfolgt entsprechend durch ein plattenförmiges Anschlusselement 5, das mittels einer Schraube 6 mit einer weiteren Stromschiene 7 verschraubt ist.

Darüber hinaus ist das obere Anschlusselement 5 mittels einer weiteren Schraube 8 und einem elektrisch isolierenden Abstandshalter 9 mit dem unteren Anschlusselement 2 verschraubt.

Der Koaxialwiderstand 1 selbst besteht im Wesentlichen aus einem innen liegenden hohlzylindrischen Kupfer-Rohr 10, zwei außen liegenden Kupfer-Ringen 11, 12 und einem Manganin^{®}-Ring 13, der in axialer Richtung zwischen den beiden Kupfer-Ringen 11, 12 angeordnet ist.

Der zu messende elektrische Strom fließt hierbei über die Stromschiene 4 und das Anschlusselement 2 in das Kupfer-Rohr 10 und fließt dort in Pfeilrichtung axial nach oben. An der oberen Stirnfläche des Koaxialwiderstands 1 ist das Kupfer-Rohr 10 durch eine Verschweißung 14 mit dem Kupfer-Ring 11 verbunden, so dass der Strom aus dem Kupfer-Rohr 10 in den Kupfer-Ring 11 übertritt und anschließend in axialer Richtung durch den Manganin^{®}-Ring 13 und den Kupfer-Ring 12 in das Anschlusselement 5 fließt, von wo er dann über die Stromschiene 7 abgeführt wird.

Zwischen den außen liegenden Kupfer-Ringen 11, 12 und dem Manganin^{®}-Ring 13 einerseits und dem innen liegenden Kupfer-Rohr 10 andererseits befindet sich hierbei ein mantelförmig umlaufender Isolationsspalt 15, so dass der Strom nicht direkt von dem Kupfer-Rohr 10 in den Kupfer-Ring 12 übertreten kann. Vielmehr bildet das Kupfer-Rohr 10 einen inneren Stromleiter, während die Kupfer-Ringe 11, 12 zusammen mit dem Manganin^{®}-Ring 13 einen äußeren Stromleiter bilden, wobei die beiden Stromleiter koaxial zueinander angeordnet sind und den zu messenden Strom in entgegen gesetzten Richtungen führen, so dass sich die von dem zu messenden Strom in dem inneren Stromleiter und in dem äußeren Stromleiter erzeugten Magnetfelder gegenseitig zumindest teilweise kompensieren. Durch diese Magnetfeldkompensation eignet sich der Koaxialwiderstand 1 auch zur Messung von elektrischen Strömen im kA-Bereich.

Bei der Strommessung wird der Spannungsabfall über dem Manganin^{®}-Ring 13 gemessen, wozu Spannungsabgriffe dienen, die an den Übergängen von dem Manganin^{®}-Ring 13 zu den beiden Kupfer-Ringen 11 bzw. 12 auf der Kupferseite an der Außenseite des Koaxialwiderstands 1 angebracht sind, wobei die Spannungsabgriffe zur Vereinfachung in den Figuren 1A und 1B nicht dargestellt sind.

Weiterhin ist zu erwähnen, dass der Manganin^{®}-Ring 13 einen kleineren stromführenden Querschnitt aufweist als die beiden Kupfer-Ringe 11, 12, da an dem Übergang von den Kupfer-Ringen 11, 12 zu dem Manganin^{®}-Ring 13 an der Außenseite des Koaxialwiderstands 1 eine Stufe vorgesehen ist, die einen sogenannten Stromschatten erzeugt.

Die Verbindung zwischen dem plattenförmigen Anschlusselement 2 und dem Kupfer-Rohr 10 erfolgt ebenfalls durch eine Verschweißung 16, jedoch kann anstelle der Verschweißungen 14, 16 auch eine Lötverbindung, eine Klebeverbindung oder eine Pressverbindung vorgesehen sein.

Ferner ist auch eine Verbindung zwischen dem Kupfer-Ring 11 und dem Manganin^{®}-Ring 13, zwischen dem Manganin^{®}-Ring 13 und dem Kupfer-Ring 12 sowie zwischen dem Kupfer-Ring 12 und dem Anschlusselement 5 vorgesehen, wobei diese Verbindungen wahlweise als Schweißverbindung, Lötverbindung, Klebeverbindung oder Pressverbindung ausgeführt sein können.

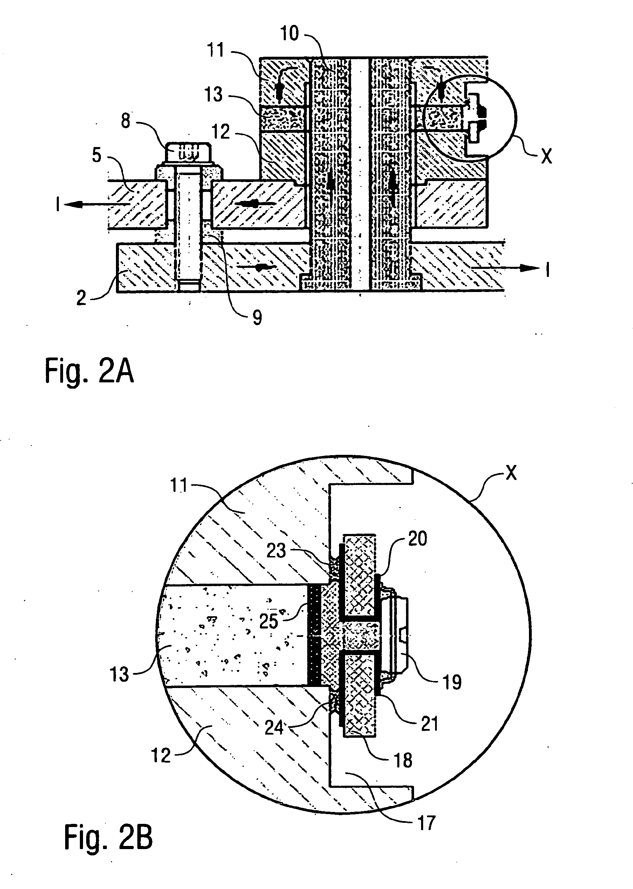

Das in den Figuren 2A und 2B dargestellte Ausführungsbeispiel stimmt weitgehend mit dem vorstehend beschriebenen und in den Figuren 1A und 1B dargestellten Ausführungsbeispiel überein, so dass zur Vermeidung von Wiederholungen auf die vorstehende Beschreibung verwiesen wird, wobei für entsprechende Bauteile dieselben Bezugszeichen verwendet werden.

Eine Besonderheit dieses Ausführungsbeispiels besteht darin, dass an der Außenseite des Koaxialwiderstands 1 eine Mulde 17 ausgebildet ist, in der eine Leiterplatte 18 mit einem A-SIC 19 (ASIC : Application-Specific Integrated Circuit) zur Spannungsmessung versenkt angeordnet ist, wobei die Leiterplatte 18 mit dem ASIC 19 in der Mulde 17 durch eine Vergussmasse vergossen werden kann, um den ASIC 19 und die Leiterplatte 18 gegenüber Umwelteinflüssen zu schützen. Anstelle des ASIC 19 kann jedoch auch ein standardisiertes IC, ein herkömmlicher Analog/Digital-Wandler oder ein sonstiges analoges Bauelement eingesetzt werden.

Die Spannungsmessung an dem Manganin^{®}-Ring 13 erfolgt hierbei durch zwei Spannungsabgriffe 20, 21, die durch jeweils eine Bohrung in der Leiterplatte 18 durchgeführt und durch eine Verlötung 23 bzw. 24 mit dem Kupfer-Ring 11 bzw. 12 verbunden sind. Die Spannungsabgriffe 20 und 21 sind hierbei nach innen angewinkelt, wodurch der Querschnitt der von den Spannungsabgriffen 20, 21 gebildeten Leiterschleife minimiert wird, wodurch die Empfindlichkeit gegenüber Störeinstrahlungen herabgesetzt wird.

Weiterhin weist der Manganin^{®}-Ring 13 hierbei an seiner äußeren Mantelfläche einen elektrisch isolierenden Schutzlack 25 auf.

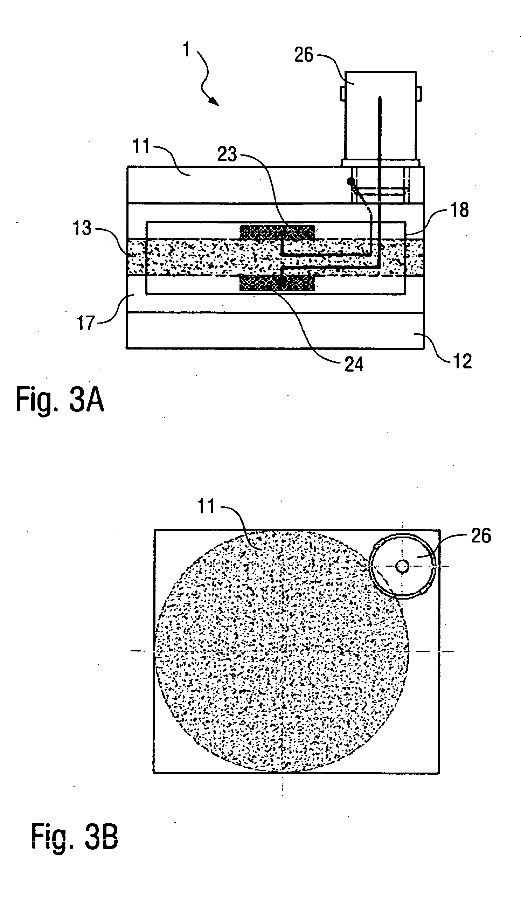

Die Figuren 3A und 3B zeigen ein alternatives Ausführungsbeispiel eines erfindungsgemäßen Koaxialwiderstands 1, das weitgehend mit dem vorstehend beschriebenen und in den Figuren 2A und 2B dargestellten Ausführungsbeispiel übereinstimmt, so dass zur Vermeidung von Wiederholungen auf die vorstehende Beschreibung verwiesen wird, wobei für entsprechende Bauteile dieselben Bezugszeichen verwendet werden.

Eine Besonderheit dieses Ausführungsbeispiels besteht darin, dass auf der Leiterplatte 18 kein ASIC 19 angeordnet ist. Vielmehr sind die Spannungsabgriffe 20, 21 hierbei mit einem BNC-Stecker 26 (BNC : Bayonet Navy Connectory) verbunden, über den der Koaxialwiderstand 1 mittels eines Koaxialkabels mit einem Messgerät verbunden werden kann.

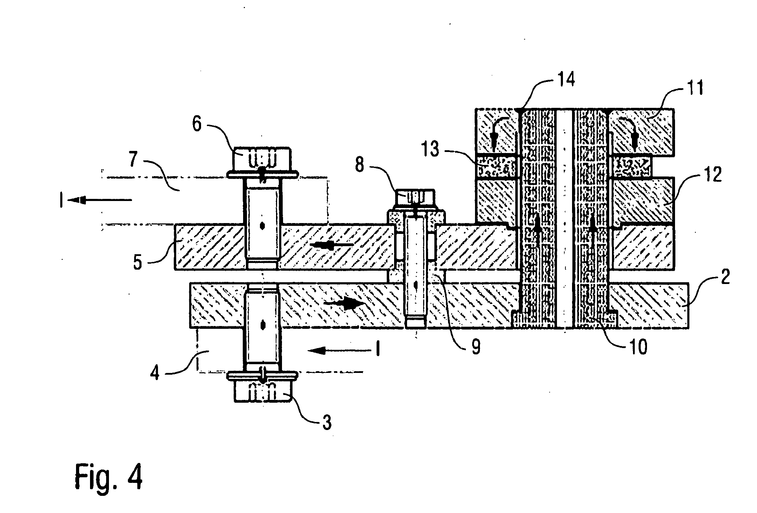

Figur 4 zeigt schließlich eine seitliche Querschnittsansicht eines alternativen Ausführungsbeispiels eines erfindungsgemäßen Koaxialwiderstands 1, das weitgehend mit dem vorstehend beschriebenen und in den Figuren 1A und 1B dargestellten Ausführungsbeispiel übereinstimmt, so dass zur Vermeidung von Wiederholungen auf die vorstehende Beschreibung zu den Figuren 1A und 1B verwiesen wird, wobei für entsprechende Bauteile dieselben Bezugszeichen verwendet werden.

Eine Besonderheit dieses Ausführungsbeispiels besteht darin, dass die plattenförmigen Anschlusselemente 2, 5 hierbei auf derselben Seite des Koaxialwiderstands 1 angeordnet sind, wohingegen die Anschlusselemente 2, 5 bei dem Koaxialwiderstand 1 gemäß den Figuren 1A und 1B auf gegenüberliegenden Seiten des Koaxialwiderstands 1 angeordnet sind.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls in den durch die unabhängigen Ansprüche definierten Schutzbereich fallen.

### Bezugszeichenliste:

- 1: Koaxialwiderstand
- 2: Anschlusselement
- 3: Schraube
- 4: Stromschiene
- 5: Anschlusselement
- 6: Schraube
- 7: Stromschiene
- 8: Schraube
- 9: Abstandshalter
- 10: Kupfer-Rohr
- 11: Kupfer-Ring
- 12: Kupfer-Ring
- 13: Manganin-Ring
- 14: Verschweißung
- 15: Isolationsspalt
- 16: Verschweißung
- 17: Mulde
- 18: Leiterplatte
- 19: ASIC
- 20: Spannungsabgriff
- 21: Spannungsabgriff
- 22: ---
- 23: Verlötung
- 24: Verlötung
- 25: Schutzlack
- 26: BNC-Stecker

## Patentansprüche

1. Koaxialwiderstand (1) zur Messung eines elektrischen Stroms, mit
a) einem innen liegenden Stromleiter (10) und
b) einem außen liegenden Stromleiter (11, 12),
c) wobei die beiden Stromleiter (10-12) koaxial zueinander angeordnet und in Reihe geschaltet sind und den Strom zur Magnetfeldkompensation in entgegen gesetzten Richtungen führen, sowie mit
d) einem niederohmigen Widerstandselement (13),
**dadurch gekennzeichnet,**
e) **dass** das niederohmige Widerstandselement (13) in dem außen liegenden Stromleiter (11, 12) angeordnet und mit dem außen liegenden Stromleiter (11, 12) in Reihe geschaltet ist.

2. Koaxialwiderstand (1) nach Anspruch 1, **dadurch gekennzeichnet, dass** sich das niederohmige Widerstandselement (13) in Stromrichtung nur über einen Teil des außen liegenden Stromleiters (10-12) erstreckt.

3. Koaxialwiderstand (1) nach einem der vorhergehenden Ansprüche, **dadurch gekennzeichnet,**
a) **dass** der innen liegende Stromleiter (10) einen Stab oder ein Rohr aufweist,
b) **dass** der außen liegende Stromleiter (11, 12) mehrere Ringe aufweist, die den Stab bzw. das Rohr des innen liegenden Stromleiters (10) umgeben, und
c) **dass** das niederohmige Widerstandselement (13) einen Ring aufweist, der den Stab bzw. das Rohr des innen liegenden Stromleiters (10) umgibt und in axialer Richtung zwischen den Ringen des außen liegenden Stromleiters (11, 12) angeordnet ist.

4. Koaxialwiderstand (1) nach einem der vorhergehenden Ansprüche, **dadurch gekennzeichnet, dass** das niederohmige Widerstandselement (13) einen kleineren stromführenden Querschnitt aufweist als der außen liegende Stromleiter (11, 12).

5. Koaxialwiderstand (1) nach Anspruch 4, **gekennzeichnet durch** eine außen liegende Stufe am Übergang von dem außen liegenden Stromleiter (11, 12) zu dem niederohmigen Widerstandselement (13).

6. Koaxialwiderstand (1) nach einem der vorhergehenden Ansprüche, **gekennzeichnet durch** zwei Spannungsabgriffe (20, 21) zur Messung der über dem niederohmigen Widerstandselement (13) abfallenden elektrischen Spannung, wobei die beiden Spannungsabgriffe (20, 21) außen angeordnet sind und vorzugsweise in Stromflussrichtung vor und hinter dem Widerstandselement (13) angeschlossen sind.

7. Koaxialwiderstand (1) nach Anspruch 6, **dadurch gekennzeichnet, dass** die Spannungsabgriffe (20, 21) angeschweißt, angelötet oder angeklebt sind.

8. Koaxialwiderstand (1) nach einem der Ansprüche 6 oder 7, **gekennzeichnet durch** eine außen angebrachte Leiterplatte (18), die mit den beiden Spannungsabgriffen (20, 21) verbunden ist.

9. Koaxialwiderstand (1) nach Anspruch 8, **dadurch gekennzeichnet, dass** die Leiterplatte (18) einen mit den beiden Spannungsabgriffen (20, 21) verbundenen Anschluss (26) für ein Koaxialkabel aufweist.

10. Koaxialwiderstand (1) nach Anspruch 8, **dadurch gekennzeichnet, dass** die Leiterplatte (18) ein IC (19) zur Spannungsmessung trägt, das mit den beiden Spannungsabgriffen (20, 21) verbunden ist und die über dem niederohmigen Widerstand (13) abfallende Spannung misst.

11. Koaxialwiderstand (1) nach einem der Ansprüche 8 bis 10, **dadurch gekennzeichnet, dass** die Leiterplatte (18) aufgelötet oder mit einem elektrisch leitfähigen Kleber befestigt ist.

12. Koaxialwiderstand (1) nach einem der Ansprüche 8 bis 11, **dadurch gekennzeichnet, dass** die Leiterplatte (18) in einer Montagemulde (17) an der Außenseite versenkt angeordnet ist.

13. Koaxialwiderstand (1) nach Anspruch 12, **dadurch gekennzeichnet, dass** die Leiterplatte (18) in der Montagemulde (17) mit einer Vergussmasse vergossen ist.

14. Koaxialwiderstand (1) nach einem der Ansprüche 8 bis 13, **dadurch gekennzeichnet, dass** die Leiterplatte (18) eine potentialfreie Schnittstelle trägt.

15. Koaxialwiderstand (1) nach einem der vorhergehenden Ansprüche, **dadurch gekennzeichnet, dass** das niederohmige Widerstandselement (13) außen eine elektrische Isolierung (25) aufweist.

16. Koaxialwiderstand (1) nach einem der vorhergehenden Ansprüche, **dadurch gekennzeichnet, dass** der innen liegende Stromleiter (10) eine Stromzuleitung ist, während der außen liegende Stromleiter (11, 12) eine Stromrückleitung ist.

17. Koaxialwiderstand (1) nach einem der vorhergehenden Ansprüche, **dadurch gekennzeichnet, dass** das niederohmige Widerstandselement (13) aus einer Kupfer-Mangan-Nickel-Legierung, insbesondere aus Cu84,Ni4Mn12, besteht.

18. Koaxialwiderstand (1) nach einem der vorhergehenden Ansprüche, **dadurch gekennzeichnet, dass** der innen liegende Stromleiter (10) und/oder der außen liegenden Stromleiter (11, 12) aus Kupfer oder einer Kupfer-Legierung besteht.

19. Koaxialwiderstand (1) nach einem der vorhergehenden Ansprüche, **gekennzeichnet durch** einen Widerstandswert von weniger als 10µΩ.

20. Koaxialwiderstand (1) nach einem der vorhergehenden Ansprüche, **gekennzeichnet durch** einen Wärmewiderstand von weniger als 0,1 K/W.

21. Verwendung eines Koaxialwiderstands (1) nach einem der vorhergehenden Ansprüche zur Messung eines elektrischen Stroms.

22. Verwendung nach Anspruch 21, **dadurch gekennzeichnet, dass** der zu messende Strom im kA-Bereich liegt.

## Claims

1. Coaxial resistor (1) for measuring an electric current, with
a) an internal conductor (10) and
b) an external conductor (10-12)
c) wherein the two conductors (10-12) are arranged coaxially to one another and are connected in series and conduct the current in opposing directions for magnetic field compensation, and also with
d) a low-resistance resistor element (13),
**characterised in that**
e) the low-resistance resistor element (13) is arranged in the external conductor (11, 12) and is connected in series with the external conductor (11, 12).

2. Coaxial resistor (1) according to claim 1, **characterised in that** the low-resistance resistor element (13) only extends over a part of the external conductor (10-12) in current direction.

3. Coaxial resistor (1) according to one of the preceding claims, **characterised in that**
a) the internal conductor (10) has a bar or a tube,
b) that the external conductor (11, 12) has a plurality of rings, which surround the bar or tube of the internal conductor (10), and
c) that the low-resistance resistor element (13) has a ring, which surrounds the bar or tube of the internal conductor (10) and is arranged in axial direction between the rings of the external conductor (11, 12).

4. Coaxial resistor (1) according to one of the preceding claims, **characterised in that** the low-resistance resistor element (13) has a smaller current-bearing cross-section than the external conductor (11, 12).

5. Coaxial resistor (1) according to claim 4, **characterised by** an external step at the transition from the external conductor (11, 12) to the low-resistance resistor element (13).

6. Coaxial resistor (1) according to one of the preceding claims, **characterised by** two voltage taps (20, 21) for measuring the electric voltage dropping out across the low-resistance resistor element (13), wherein the two voltage taps (20, 21) are arranged on the outside and are preferably connected in front of and behind the resistor element (13) in the current flow direction.

7. Coaxial resistor (1) according to claim 6, **characterised in that** the voltage taps (20, 21) are welded, soldered or glued in place.

8. Coaxial resistor (1) according to one of claims 6 or 7, **characterised by** an externally attached circuit board (18), which is connected to the two voltage taps (20, 21).

9. Coaxial resistor (1) according to claim 8, **characterised in that** the circuit board (18) has a connection (26) for a coaxial cable connected to the two voltage taps (20, 21).

10. Coaxial resistor (1) according to claim 8, **characterised in that** the circuit board (18) bears an IC (19) for voltage measurement, which is connected to the two voltage taps (20, 21) and measures the voltage dropping out across the low-resistance resistor (13).

11. Coaxial resistor (1) according to one of claims 8 to 10, **characterised in that** the circuit board (18) is soldered in place or is fastened with an electrically conductive adhesive.

12. Coaxial resistor (1) according to one of claims 8 to 11, **characterised in that** the circuit board (18) is arranged sunken in an assembly cavity (17) on the outside.

13. Coaxial resistor (1) according to claim 12, **characterised in that** the circuit board (18) is sealed in the assembly cavity (17) with a sealing compound.

14. Coaxial resistor (1) according to one of claims 8 to 13, **characterised in that** the circuit board (18) bears a potential-free interface.

15. Coaxial resistor (1) according to one of the preceding claims, **characterised in that** the low-resistance resistor element (13) has an electrical insulation (25) on the outside.

16. Coaxial resistor (1) according to one of the preceding claims, **characterised in that** the internal conductor (10) is a current supply wire, whereas the external conductor (11, 12) is a current return wire.

17. Coaxial resistor (1) according to one of the preceding claims, **characterised in that** the low-resistance resistor element (13) is made of a copper-manganese-nickel alloy, in particular Cu84,Ni4Mn12.

18. Coaxial resistor (1) according to one of the preceding claims, **characterised in that** the internal conductor (10) and/or the external conductor (11, 12) are made of copper or a copper alloy.

19. Coaxial resistor (1) according to one of the preceding claims, **characterised by** a resistance value of less than 10 µΩ.

20. Coaxial resistor (1) according to one of the preceding claims, **characterised by** a thermal resistance of less than 0.1 K/W.

21. Use of a coaxial resistor (1) according to one of the preceding claims for measuring an electrical current.

22. Use according to claim 21, **characterised in that** the current to be measured lies in the kA range.

## Revendications

1. Résistance coaxiale (1) pour la mesure d'un courant électrique, avec
a) un conducteur de courant intérieur (10) et
b) un conducteur de courant extérieur (11, 12),
c) les deux conducteurs de courant (10-12) étant disposés coaxialement l'un à l'autre et montés en série, et conduisant le courant dans des directions opposées pour une compensation de champ magnétique, ainsi qu'avec
d) un élément de résistance de faible impédance (13),
**caractérisée**
e) **en ce que** l'élément de résistance de faible impédance (13) est disposé dans le conducteur de courant extérieur (11, 12) et est monté en série avec le conducteur de courant extérieur (11, 12).

2. Résistance coaxiale (1) selon la revendication 1, **caractérisée en ce que** l'élément de résistance de faible impédance (13) ne s'étend que sur une partie du conducteur de courant extérieur (11, 12) dans la direction du courant.

3. Résistance coaxiale (1) selon l'une des revendications précédentes, **caractérisée**
a) **en ce que** le conducteur de courant intérieur (10) comporte une barre ou un tube,
b) **en ce que** le conducteur de courant extérieur (11, 12) comporte plusieurs bagues qui entourent la barre ou le tube du conducteur de courant intérieur (10), et
c) **en ce que** l'élément de résistance de faible impédance (13) comporte une bague qui entoure la barre ou le tube du conducteur de courant intérieur (10) et qui est disposé entre les bagues du conducteur de courant extérieur (11, 12) en direction axiale.

4. Résistance coaxiale (1) selon l'une des revendications précédentes, **caractérisée en ce que** l'élément de résistance de faible impédance (13) présente une section conductrice de courant inférieure à celle du conducteur de courant extérieur (11, 12).

5. Résistance coaxiale (1) selon la revendication 4, **caractérisée par** un gradin extérieur sur la transition entre le conducteur de courant extérieur (11, 12) et l'élément de résistance de faible impédance (13).

6. Résistance coaxiale (1) selon l'une des revendications précédentes, **caractérisée par** deux prises de tension (20, 21) pour la mesure de la tension électrique passant par l'élément de résistance de faible impédance (13), les deux prises de tension (20, 21) étant disposées extérieurement et de préférence raccordées devant et derrière l'élément de résistance de faible impédance (13) dans la direction de circulation du courant.

7. Résistance coaxiale (1) selon la revendication 6, **caractérisée en ce que** les prises de tension (20, 21) sont rapportées par soudage, par brasage ou par collage.

8. Résistance coaxiale (1) selon l'une des revendications 6 ou 7, **caractérisée par** une carte (18) extérieurement appliquée et qui est reliée aux deux prises de tension (20, 21).

9. Résistance coaxiale (1) selon la revendication 8, **caractérisée en ce que** la carte (18) comporte une connexion (26) pour un câble coaxial reliée aux deux prises de tension (20, 21).

10. Résistance coaxiale (1) selon la revendication 8, **caractérisée en ce que** la carte (18) supporte un circuit imprimé (19) pour la mesure de tension, qui est relié aux deux prises de tension (20, 21) et qui mesure la tension passant par l'élément de résistance de faible impédance (13).

11. Résistance coaxiale (1) selon l'une des revendications 8 à 10, **caractérisée en ce que** la carte (18) est brasée ou fixée au moyen d'une colle électriquement conductrice.

12. Résistance coaxiale (1) selon l'une des revendications 8 à 11, **caractérisée en ce que** la carte (18) est enfoncée dans une poche de montage (17) sur le côté extérieur.

13. Résistance coaxiale (1) selon la revendication 12, **caractérisée en ce que** la carte (18) est scellée par une masse de scellement dans la poche de montage (17).

14. Résistance coaxiale (1) selon l'une des revendications 8 à 13, **caractérisée en ce que** la carte (18) supporte une interface exempte de potentiel.

15. Résistance coaxiale (1) selon l'une des revendications précédentes, **caractérisée en ce que** l'élément de résistance de faible impédance (13) comporte une isolation électrique (25) extérieure.

16. Résistance coaxiale (1) selon l'une des revendications précédentes, **caractérisée en ce que** le conducteur de courant intérieur (10) est une ligne d'amenée de courant, tandis que le conducteur de courant extérieur (11, 12) est une ligne de retour de courant.

17. Résistance coaxiale (1) selon l'une des revendications précédentes, **caractérisée en ce que** l'élément de résistance de faible impédance (13) est composé d'un alliage cuivre-manganèse-nickel, en particulier de Cu84, Ni4Mn12.

18. Résistance coaxiale (1) selon l'une des revendications précédentes, **caractérisée en ce que** le conducteur de courant intérieur (10) et/ou le conducteur de courant extérieur (11, 12) sont composés de cuivre ou d'un alliage de cuivre.

19. Résistance coaxiale (1) selon l'une des revendications précédentes, **caractérisée par** une résistance inférieure à 10 µΩ.

20. Résistance coaxiale (1) selon l'une des revendications précédentes, **caractérisée par** une résistance thermique inférieure à 0,1 K/W.

21. Utilisation d'une résistance coaxiale (1) selon l'une des revendications précédentes pour la mesure d'un courant électrique.

22. Utilisation selon la revendication 21, **caractérisée en ce que** le courant à mesurer est de l'ordre des kA.
